# EUROPÄISCHE PATENTSCHRIFT

(11) **EP 0 645 957 B1**
(45) Veröffentlichungstag und Bekanntmachung des Hinweises auf die Patenterteilung: **13.11.1996**
(21) Anmeldenummer: 94113980.0
(22) Anmeldetag: 07.09.1994
(51) Int. Cl.: H05K 7/18

(54) **Gestellrahmen**
Cabinet frame
Ossature d'armoire

(30) Priorität: 28.09.1993 DE 4333207
(43) Veröffentlichungstag der Anmeldung: 29.03.1995
(73) Patentinhaber: Rittal-Werk Rudolf Loh GmbH & Co. KG, 35745 Herborn (DE)
(72) Erfinder: Besserer, Horst, D-35745 Herborn (DE); Bovermann, Klaus-Dieter, D-35236 Breidenbach-Niederdieten (DE); Hartel, Marc, D-35447 Reiskirchen (DE)
(74) Vertreter: Fleck, Hermann-Josef, Dr.-Ing.

(56) Entgegenhaltungen:
- DE-C- 4 105 548
- DE-C- 4 109 695
- GB-A- 2 052 878

## Beschreibung

Die Erfindung betrifff einen Gestellrahmen mit zwei vorderen und zwei hinteren vertikalen Trägern, der bis auf die Vorderseite mit Wandelementen verschließbar ist und in den über die offene Vorderseite Baueinheiten einbaubar sind, wobei an den beiden vorderen Trägern Halterungen angebracht oder anbringbar sind, an denen die Baueinheiten befestigbar sind; (siehe z.B. DE-C-4 105 548).

Bei derartigen Gestellrahmen sind die Träger mit Befestigungsaufnahmen versehen. Die Wandelemente können mittels Befestigungswinkeln mit den Befestigungsaufnahmen verbunden werden, oder sie können je nach Anordnung der Befestigungsaufnahmen direkt mit den Trägern verschraubt werden. Ein teilweises Verschließen beispielsweise einer Seitenwand mit mehreren als Teilplatten ausgebildeten Wandelementen ist mit einem solchen Gestellrahmen nicht möglich. Zur Umgehung dieses Nachteils ist nach einer anderen Ausführung eines Gestellrahmens vorgesehen, die Träger in Längsrichtung mit Reihen von Befestigungsaufnahmen zu versehen. Die Befestigungsaufnahmen sind dabei vorzugsweise in gleicher Teilung angeordnet. Mit einem solchen Gestellrahmen können Teilplatten an vorgegebenen Positionen an den Trägern befestigt werden.

Es ist Aufgabe der Erfindung, einen Gestellrahmen der eingangs erwähnten Art zu schaffen, an dessen vertikalen Trägern Wandelemente schnell und auf einfache Weise in beliebiger Höhe anbringbar sind und bei dem Baueinheiten mit verschiedener Einbautiefe auf einfache Weise so befestigt werden können, daß sie entweder rückseitig oder frontseitig miteinander bündig abschließen.

Die Aufgabe der Erfindung wird dadurch gelöst, daß in die senkrecht zueinander stehenden Außenseiten der hinteren Träger Längsschlitze zur Aufnahme von abgekanteten Rändern der Wandelemente eingebracht sind, daß die hinteren Träger parallel zu den Wandelementen im Abstand verlaufende Befestigungsstege für verstellbare U-förmige Befestigungselemente aufweisen, an denen die Wandelemente anbringbar sind, daß die vorderen Träger an den seitlichen Außenflächen Längsschlitze zur Aufnahme von abgekanteten Rändern der seitlichen Wandelemente aufweisen, daß die vorderen Träger parallel zu diesen Wandelementen im Abstand verlaufende Befestigungsstege für verstellbare U-förmige Befestigungselemente aufweisen, an denen diese Wandelemente anbringbar sind, und daß die vorderen Träger auf den zu den Außenflächen parallelen Innenflächen Längsaufnahmen für die Halterungen aufweisen, an denen die Halterungen tiefenverstellbar anbringbar sind.

Die Befestigungselemente können an den Befestigungsstegen angebracht und an diesen bis zu einer gewünschten Position hin verschoben werden. In dieser Position kann das Befestigungselement fixiert und mit dem Wandelement verbunden werden. Auf diese Weise kann beispielsweise eine Seitenwand mit mehreren Teil-Wandelementen teilweise verschlossen werden. Dies kann dann von Bedeutung sein, wenn mehrere Gestellrahmen nebeneinander gereiht aufgestellt sind und Verbindungsleitungen von einem Gestellrahmen zum nächsten Gestellrahmen durch die Seitenwände geführt sind. Desweiteren ermöglichen abnehmbare Teil-Wandelemente einen einfachen und schnellen Zugang zu bestimmten Sektoren des Gestellrahmens. Dies ist vor allem für Wartungszwecke vorteilhaft.

Ein an den Befestigungselementen festgelegtes Wandelement kann mittels der Befestigungsstege beliebig an den Trägern bis zu einer gewünschten Position hin verschoben werden. In dieser Stellung können die Befestigungselemente arretiert werden, so daß auch das Wandelement fixiert ist. Die Wandelemente können mit ihren Rändern einfach in die Längsschlitze eingesetzt und damit vorpositioniert werden, so daß sie ohne großen Zeitaufwand befestigt werden können.

Mittels der verstellbaren Halterungen können die einzelnen Baueinheiten in Richtung der Tiefe des Gestellrahmens so verschoben werden, daß sie vorderseitig oder rückseitig eine gemeinsame Ebene bilden. Dabei kann die Verstellbarkeit so ausgebildet sein, daß sie entweder stufenlos oder gerastert in Teilschritten möglich ist. Baueinheiten mit gleicher Einbautiefe können an einer Halterung angebracht sein. Sollen beispielsweise mehrere Baugruppenträger, die in Zollteilung ausgebildet sind, mit solchen Baugruppenträgern, die in metrischer Teilung ausgebildet sein, in einem Gestellrahmen eingebaut werden, dann werden zwei Halterungen übereinander an den vorderen Trägern angebracht. An den Halterungen werden dann jeweils die unterschiedlichen Baugruppenträger befestigt und können im Gestellrahmen in eine Position gebracht werden, in der die rückseitigen Anschlußwände sowohl der in metrischer, als auch der in Zollteilung ausgebildeten Baugruppenträger eine gemeinsame Anschlußebene bilden.

Die Verstell- und Arretierbarkeit der Halterungen in Richtung der Tiefe des Gestellrahmens bietet auch Vorteile in der optimalen Ausnutzung des Raumes im vorderen Bereich des Gestellrahmens. Zum Beispiel lassen sich größere Bedienelemente, die in der Tiefe stark auftragen, noch plazieren.

Nach einer Ausgestaltung sieht die Erfindung vor, daß an dem Träger ein gegenüber der Außenseite des Trägers in Richtung zum Innenraum des Gestellrahmens hin versetzter vertikaler Anlagesteg angeordnet ist, daß der Befestigungssteg gegenüber dem Anlagesteg hin Richtung zum Innenraum des Gestellrahmens hin versetzt ist und daß sich das Wandelement mit seiner Innenseite auf dem Anlagesteg abstützt.

Die Befestigungselemente sind hinter dem Wandelement, dem Innenraum des Gestellrahmens zugekehrt angeordnet. Damit können die Wandelemente von der Außenseite des Gestellrahmens her einfach angebracht werden. Zudem ist das Befestigungselement mit dem Wandelement abgedeckt, so daß es optisch nicht als störend empfunden wird.

Ist zudem noch zusätzlich vorgesehen, daß der Anlagesteg des Trägers gegenüber der Außenseite des Trägers um die Dicke des Wandelementes zurückgesetzt ist, dann schließt das Wandelement bündig mit der Außenseite des Trägers ab.

Eine Ausgestaltung der Erfindung ist dadurch gekennzeichnet, daß der Anlagesteg sich an den Längsschlitz des Trägers anschließt. Damit ist verhindert, daß am Träger im Anschluß an den Rand des Wandelementes kein zur Außenseite des Gestellrahmens gerichteter Schlitz entsteht.

Ist vorgesehen, daß der Gestellrahmen feuchtigkeitsdicht verschlossen werden soll, dann ist es möglich, daß in den Längsschlitz des Trägers Dichtelemente eingelegt oder einlegbar sind. Die Stirnseite des Randes des Wandelementes wird dann im Grund des Längsschlitzes mit dem Dichtelement verpreßt. Als Dichtelement kann beispielsweise eine Dichtschnur aus Gummi verwendet sein. Es ist aber auch möglich, daß auf dem Anlagesteg oder auf der dem Anlagesteg zugekehrten Innenseite des Wandelementes ein Dichtelement angebracht ist.

Nach einer bevorzugten Variante ist vorgesehen, daß die Befestigungsstege mit Hinterschnitt ausgebildet sind und am vorderen Träger und am hinteren Träger gegeneinander gerichtet sind. Damit sind zwei Hinterschnitte gebildet, an denen ein entsprechend ausgebildetes Befestigungselement gehalten und in Längsrichtung des Längsschlitzes stufenlos verstellbar ist.

Eine Ausgestaltungsmöglichkeit ist dadurch gekennzeichnet, daß das Befestigungselement zwei zueinander parallel beabstandete Schenkel aufweist, die den Befestigungssteg beidseitig übergreifen, daß der dem Wandelement zugekehrte Schenkel eine Schraubenaufnahme und der dem Wandelement abgekehrte Schenkel fluchtend zur Schraubenaufnahme eine Gewindeaufnahme aufweist, daß das Wandelement fluchtend zur Schraubenaufnahme eine weitere Schraubenaufnahme aufweist, und daß eine Befestigungsschraube in die Schraubenaufnahmen eingeführt und in die Gewindeaufnahme eingeschraubt ist. Das Befestigungselement ist als einfaches Bauteil ausgestaltet und ist somit kostengünstig zu fertigen. Die beiden Schenkel können je nach Materialauswahl elastisch am Befestigungssteg verspannt werden und federn wieder, nachdem die Befestigungsschraube gelöst ist, in ihre Ausgangsstellung zurück. Das Befestigungselement kann dann wieder am Befestigungssteg verschoben werden.

Zur einfachen Anbringbarkeit des Befestigungselementes am Befestigungssteg ist vorgesehen, daß die Schenkel des Befestigungselementes parallel zu dem Wandelement stehen und an den vorderen Trägern zur Vorderseite und an den hinteren Trägern zur Rückseite hin gerichtet sind. Somit kann auch die Befestigungsschraube, die das Wandelement hält, bequem von der Außenseite des Wandelementes her eingeführt und verschraubt werden.

Nach einer vorteilhaften Ausgestaltung ist vorgesehen, daß die Aufnahmen an den einander zugekehrten Innenseiten der vorderen Träger als Absätze ausgebildet sind, die zur Vorderseite hin in einen Anschlag übergehen, dann kann der vordere Träger als einfaches Teil ausgebildet sein. Der Anschlag legt die Halterung in einer Ausgangsstellung fest, von der aus sie um das gewünschte Maß verschoben werden kann.

Eine bevorzugte Ausgestaltung eines Gestellrahmens ist dadurch gekennzeichnet, daß der vordere Träger einen längsgerichteten Haltesteg aufweist, an dem ein U-förmiges Befestigungselement längs verschiebbar ist und daß in den Schenkel der Halterung ein in Richtung der Tiefe des Gestellrahmens verlaufendes Langloch eingebracht ist, in das eine Befestigungsschraube einführbar und mit einer Gewindeaufnahme des Befestigungselementes verschraubbar ist. Das U-förmige Befestigungselement kann einfach mit dem Haltesteg verbunden, beispielsweise aufgeklipst, werden. An dem Haltesteg können die Befestigungselemente stufenlos in Richtung der Höhe des Gestellrahmens an den vorderen Trägern verschoben werden. Damit können auch die Halterungen stufenlos verstellt werden, so daß die Einbauhöhe der Einbauten frei einstellbar ist.

Ist vorgesehen, daß der Haltesteg gegenüber der Außenseite des vorderen Trägers parallel nach innen versetzt ist und sich an den Absatz des vorderen Trägers anschließt, dann kann die Halterung beabstandet zur Außenseite des Gestellrahmens befestigt werden. Somit können an den Trägern Seitenwände angebracht werden, mittels derer der Gestellrahmen verschließbar ist. Die Verstellmöglichkeit der Halterungen bleibt dadurch unbeeinflußt.

Eine vorteilhafte Ausgestaltung des Befestigungselementes ist dadurch gekennzeichnet, daß das Befestigungselement zwei den Haltesteg beidseitig übergreifende Schenkel aufweist, von denen der dem Winkelstück abgekehrte Schenkel die Gewindeaufnahme und der dem Winkelstück zugekehrte Schenkel eine hierzu fluchtende Schraubenaufnahme aufweisen.

Die einfache Anbringung des Befestigungselementes an dem Haltesteg und die gut zugängliche Befestigung der Halterung ist dann möglich, wenn vorgesehen ist, daß die Schenkel des Befestigungselementes zur Vorderseite des Gestellrahmens hin gerichtet sind.

Ist ein Gestellrahmen dadurch gekennzeichnet, daß die Halterung mit ihrem Schenkel auf einer Tiefenstrebe aufgeschraubt ist und daß die Tiefenstrebe mit einem Halteansatz an dem vorderen Träger befestigt ist, dann ermöglicht die Tiefenstrebe auch den Einbau von beispielsweise Baugruppenträgern mit nur geringer Einbautiefe. Dabei können die Tiefenstreben sich als Führung auch über die gesamte Tiefe des Gestellrahmens erstrecken. Sie sind dann vorzugsweise auch an den hinteren vertikalen Trägern befestigt. Damit können auch Einbauten mit hohem Gewicht sicher festgelegt und geführt werden.

Dabei ist es auch möglich, daß der Halteansatz der Tiefenstrebe mittels des Befestigungselementes an dem Haltesteg des vorderen Trägers festlegbar ist. Die Tiefenstrebe ist somit auch in der Höhe des Gestellrahmens stufenlos verstellbar.

Die Erfindung wird im folgenden anhand von in den Zeichnungen dargestellten Ausführungsbeispielen näher erläutert. Es zeigen:
- Fig. 1: in perspektivischer Darstellung einen Teil eines Gestellrahmens mit einem Sockel,
- Fig. 2: in Draufsicht und Explosionsdarstellung einen Träger sowie ein Wand- und ein Befestigungselement,
- Fig. 3: in perspektivischer Darstellung einen Abschnitt eines vorderen und eines hinteren vertikalen Träger eines Gestellrahmens, an denen eine Seitenwand sowie eine Rückwand befestigt ist,
- Fig. 4: in Draufsicht den vorderen Träger nach Fig. 3 mit einer Halterung, und
- Fig. 5: in Draufsicht den vorderen Träger nach Fig. 3 mit einer Tiefenstrebe.

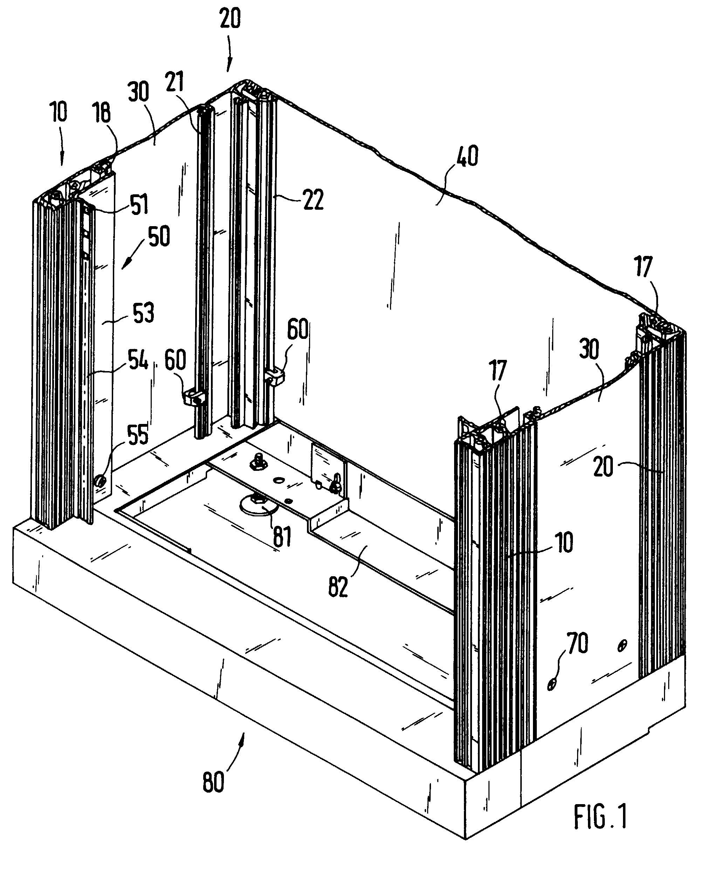

In Fig. 1 ist ein Teil eines Gestellrahmens mit vier vertikalen Trägern 10,20 und einem Sockel 80 gezeigt. An dem Sockel 80 ist eine Querstrebe 82 befestigt. Die Querstrebe 82 verläuft horizontal in der Breite des Gestellrahmens. In die Querstrebe 82 sind im Bereich der Seiten des Gestellrahmens Bohrungen eingebracht, in die Stellfüße 81 mit ihren Gewindebolzen eingesetzt sind. Mit den Stellfüßen 81 kann der Gestellrahmen lotrecht ausgerichtet werden.

Der Sockel 80 weist Befestigungsaufnahmen auf, in die von seiner Unterseite her Befestigungsschrauben eingeführt und in längsgerichtete Schraubkanäle 17 der Träger 10, 20 eingeschraubt werden können.

An den beiden vorderen Trägern 10 sind als Winkelleisten ausgebildete Halterungen 50 angebracht. Die Halterungen 50 weisen einen Schenkel 53 auf, an dem rechtwinklig ein Halteansatz 54 angeformt ist. Der Halteansatz 54 ist mit einer Reihe von Befestigungsaufnahmen 51 versehen. Die Halterungen 50 sind an den Innenseiten der beiden vorderen Träger 10 so angebracht, daß die Befestigungssätze 54 einander zugekehrt sind. Die Befestigung an den vorderen Trägern 10 erfolgt mittels Befestigungsschrauben 55, die in Langlöcher des Schenkels 53 eingeführt und in mit den vorderen Trägern 10 verbindbare Befestigungselemente 60 eingeschraubt sind. Das Befestigungselement 60 ist auf einem längsgerichteten Klemmsteg 18 des vorderen Trägers 10 befestigt. An den Halteansätzen 54 der Halterungen 50 sind mittels der Befestigungsaufnahmen 51 Einbauten, beispielsweise Baugruppenträger, befestigbar.

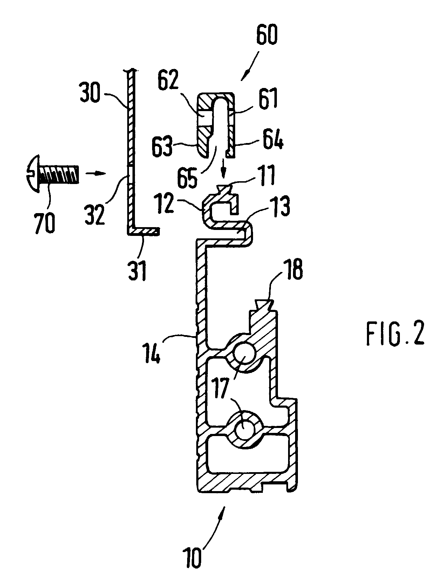

Die Seitenwände und die Rückwand des Gestellrahmens sind mittels Wandelementen 30,40 verschlossen, wie dies in Fig. 1 deutlicher gezeigt ist. Die Fig. 2 zeigt in Explosionsdarstellung den vorderen Träger nach Fig. 1, sowie ein Wandelement 30 und ein Befestigungselement 60. Der vordere Träger 10 weist einen längsgerichteten Befestigungssteg 11 auf, an dem Befestigungselemente 60 verschiebbar angebracht sind. Der Befestigungssteg 11 ist im Querschnitt V-förmig ausgebildet, wobei er sich in Richtung zum Träger 10 hin verjüngt. Der Befestigungssteg 11 ist gegenüber dem Wandelement 30 dem Innenraum des Gestellrahmens zugekehrt versetzt.

Das Befestigungselement weist zwei zueinander parallel beabstandete Schenkel 63, 64 auf, die zwischen sich eine Aufnahme 65 ausbilden, so daß die Schenkel 63, 64 den Befestigungsteg 11 beidseitig übergreifen. Dabei sind die Schenkel 63, 64 an den V-förmigen Befestigungssteg 11 angepaßt ausgebildet, so daß dieser formschlüssig übergriffen wird. Die beiden Schenkel 63, 64 sind parallel zu dem Wandelement 30 ausgerichtet. Der dem Wandelement 30 zugekehrte Schenkel 63 ist mit einer Schraubenaufnahme 62 versehen, die gegenüber dem Haltesteg 11 versetzt angeordnet ist. Fluchtend zu der Schraubenaufnahme 62 ist in den dem Wandelement 30 abgekehrten Schenkel 64 eine Gewindeaufnahme 61 eingebracht. Das Wandelement 30 ist ebenfalls mit einer Schraubenaufnahme 32 versehen, die deckungsgleich über der Schraubenaufnahme 62 des Schenkels 63 positioniert werden kann.

In die Schraubenaufnahmen 32 und 62 ist eine Befestigungsschraube 70 von der Außenseite des Gestellrahmens her einführbar und in der Gewindeaufnahme 61 des Schenkels 64 verschraubbar. Hierbei verspannen die beiden Schenkel 63,64 den Befestigungssteg 11 in der Aufnahme 65, so daß sowohl das Befestigungselement 60 als auch das Wandelement 30 am vorderen Träger 10 fixiert ist. Dieser Befestigungsmechanismus ist für die beiden hinteren Träger 20 analog angewendet, wie dies in Fig. 1 gezeigt ist.

Die Wandelemente 30 sind seitlich mit vertikalen Rändern 31 versehen, die in Längsschlitze 13 der Träger 10,20 eingesetzt sind. An die Längsschlitze 13 ist ein Anlagesteg 12 angeschlossen, der gegenüber der Profilaußenseite 14 um das Maß zum Innenraum des Gestellrahmens hin versetzt ist, das der Dicke des Wandelementes 30 entspricht. Somit kann das Wandelement 30 mit seinen Abkantungen 31 in die Längsschlitze 13 eingesetzt werden. Die Einsetzbewegung ist mit dem Anlagesteg 12 begrenzt, der an der Innenseite des Wandelementes 30 anschlägt.

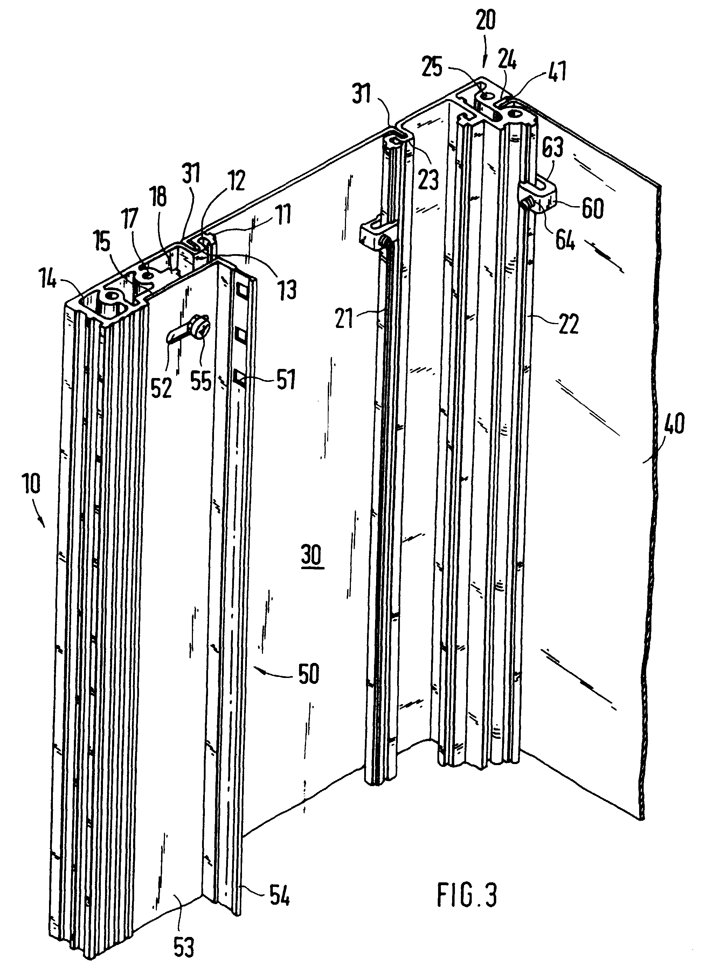

In Fig. 3 ist ein Teil eines Gestellrahmens mit einem vorderen und einem hinteren vertikalen Träger 10 und 20 dargestellt. Der Gestellrahmen ist mittels seitlichen Wandelementen 30 und einem hinteren Wandelement 40 verschließbar.

An dem vorderen Träger 10 ist eine Halterung 50 angebracht. Die Halterung 50 ist als Winkelstück ausgebildet, das aus einem Schenkel 53 besteht, an dem rechtwinklig ein Befestigungsansatz 54 angeformt ist. Der Befestigungsansatz 54 verläuft parallel zur Vorderseite des Gestellrahmens und ist mit einer Reihe von in gleicher Teilung eingebrachten Befestigungsaufnahmen 51 versehen. Die Befestigungsansätze 54 der an den vorderen Trägern 10 befestigten Halterungen 50 sind einander zugekehrt.

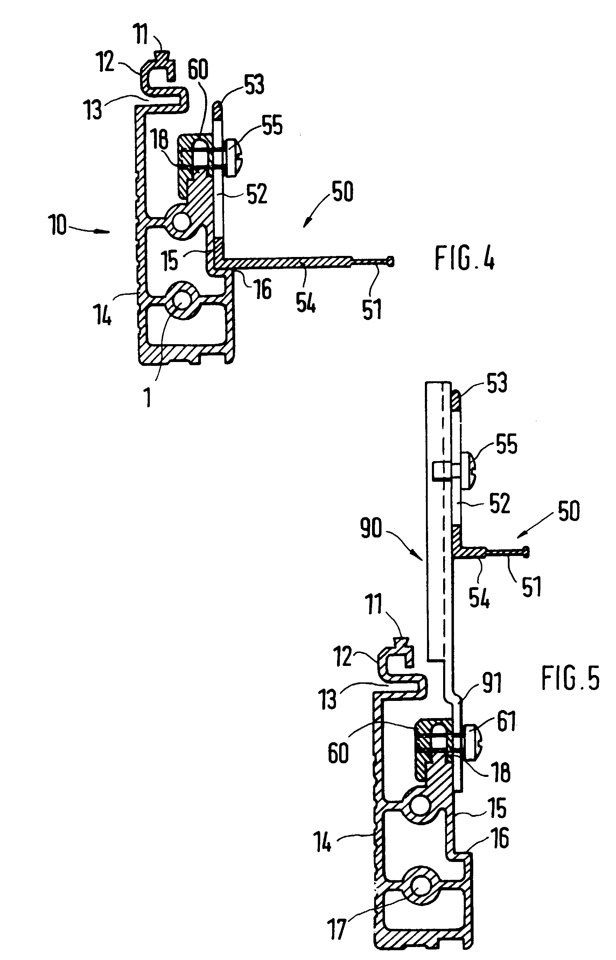

An den Befestigungsaufnahmen 51 können in das Innere des Gestellrahmens ragende Baueinheiten befestigt werden. Die Halterung 50 ist mit in Richtung der Schranktiefe verlaufenden Langlöchern 52 versehen. In die Langlöcher 52 sind Befestigungsschrauben 55 eingesetzt und mit Befestigungselementen 60 verschraubt, wie das die Fig. 4 deutlicher zeigt. In dieser Darstellung ist der vordere Träger 10 in Draufsicht dargestellt. Die Halterung 50 ist mit dem Schenkel 53 in eine Längsaufnahme 15 des vorderen Trägers 10 eingesetzt. Die Längsaufnahmen 15 sind an den einander zugekehrten Innenseiten der vorderen Träger 10 als Absätze ausgebildet, die zur Vorderseite hin in einen Anschlag 16 übergehen.

Rückseitig geht der Absatz in einen längsgerichteten Haltesteg 18 über. Auf den Haltesteg 18 ist das Befestigungselement 60 aufgeklipst. Das Befestigungselement 60 weist zwei parallele Schenkel 63, 64 auf, von denen der der Halterung 50 abgekehrte Schenkel 64 eine Gewindeaufnahme 61 trägt. Der der Halterung 50 zugekehrte Schenkel 63 weist zur Gewindeaufnahme 61 fluchtend eine Schraubenaufnahme 62 auf. Die Befestigungsschraube 55 ist in das Langloch 52 der Halterung 50 und in die Schraubenaufnahme 62 des einen Schenkels 63 eingeführt und in der Gewindeaufnahme 61 des anderen Schenkels 64 verschraubt. Damit werden die beiden Schenkel 63, 64 des Befestigungselementes 60 am Haltesteg 18 verspannt und die Halterung 50 am vorderen Träger 10 festgelegt. Wird die Befestigungsschraube 55 wieder gelöst, dann kann der Befestigungsansatz 54 mittels des Langloches 52 in Richtung der Tiefe des Gestellrahmens und zum anderen die Halterung 50 stufenlos in Richtung der Höhe des Gestellrahmens am vorderen Träger 10 verstellt werden.

In Fig. 5 ist eine weitere Ausführungsform einer erfindungsgemäßen Halterung 50 gezeigt. Die Halterung 50 ist hierbei aus einer Tiefenstrebe 90 und einem Winkelstück zusammengesetzt. Die Tiefenstrebe 90 weist an ihrer, dem vorderen Träger 10 zugekehrten Seite einen Halteansatz 91 auf, in den eine Schraubenaufnahme eingebracht ist. Die Tiefenstrebe 90 ist mit dem vorderen Träger 10 in der oben geschilderten Weise mit den Befestigungselementen 60 und der Befestigungsschraube 61 verbindbar. Somit kann die Tiefenstrebe 90 in Richtung der Höhe des Gestellrahmens stufenlos verstellt werden.

Auf der Tiefenstrebe 90 ist das Winkelstück mit dem Schenkel 53 befestigt und kann mittels des Langloches 52 und der Befestigungsschraube 55 hieran stufenlos verstellt werden.

In die Tiefenstrebe 90 sind zueinander versetzt in gleicher Teilung Gewindeaufnahmen eingebracht, in die die Befestigungsschraube 55 einschraubbar ist. Damit ist über die gesamte Länge der Tiefenstrebe 90 mit dem Winkelstück eine Verstellmöglichkeit geschaffen.

## Patentansprüche

1. Gestellrahmen mit zwei vorderen und zwei hinteren vertikalen Trägern, der bis auf die Vorderseite mit Wandelementen verschließbar ist und in den über die offene Vorderseite Baueinheiten einbaubar sind, wobei an den beiden vorderen Trägern Halterungen angebracht oder anbringbar sind, an denen die Baueinheiten befestigbar sind,
dadurch gekennzeichnet,
daß in die senkrecht zueinander stehenden Außenseiten der hinteren Träger (20) Längsschlitze (23,24) zur Aufnahme von abgekanteten Rändern (31,41) der Wandelemente (30,40) eingebracht sind,
daß die hinteren Träger (20) parallel zu den Wandelementen (30,40) im Abstand verlaufende Befestigungsstege (21,22) für verstellbare U-förmige Befestigungselemente (60) aufweisen, an denen die Wandelemente (30,40) anbringbar sind,
daß die vorderen Träger (10) an den seitlichen Außenflächen (14) Längsschlitze (13) zur Aufnahme von abgekanteten Rändern (31) der seitlichen Wandelemente (30) aufweisen,
daß die vorderen Träger (10) parallel zu diesen Wandelementen (30) im Abstand verlaufende Befestigungsstege (11) für verstellbare U-förmige Befestigungselemente (60) aufweisen, an denen diese Wandelemente (30) anbringbar sind, und
daß die vorderen Träger (10) auf den zu den seitlichen Außenflächen (14) parallelen Innenflächen Längsaufnahmen (15) für die Halterungen (50) aufweisen, an denen die Halterungen (50) tiefenverstellbar anbringbar sind.

2. Gestellrahmen nach Anspruch 1,
dadurch gekennzeichnet,
daß an dem Träger (10,20) ein gegenüber der Außenseite des Trägers (10,20) in Richtung zum Innenraum des Gestellrahmens hin versetzter vertikaler Anlagesteg (12) angeordnet ist,
daß der Befestigungssteg (11,21,22) gegenüber dem Anlagesteg (12) in Richtung zum Innenraum des Gestellrahmens hin versetzt ist, und
daß sich das Wandelement (30,40) mit seiner Innenseite auf dem Anlagesteg (12) abstützt.

3. Gestellrahmen nach Anspruch 2,
dadurch gekennzeichnet,
daß der Anlagesteg (12) des Trägers (10,20) gegenüber der Außenseite des Trägers (10,20) um die Dicke des Wandelementes (30,40) zurückgesetzt ist.

4. Gestellrahmen nach Anspruch 2 oder 3,
dadurch gekennzeichnet,
daß der Anlagesteg (12) sich an den Längsschlitz (13,23,24) des Trägers (10,20) anschließt.

5. Gestellrahmen nach einem der Ansprüche 1 bis 4,
dadurch gekennzeichnet,
daß in den Längsschlitz (13,23,24) des Trägers (10,20) Dichtelemente eingelegt oder einlegbar sind.

6. Gestellrahmen nach einem der Ansprüche 2 bis 4,
dadurch gekennzeichnet,
daß auf dem Anlagesteg (12) oder auf der dem Anlagesteg (12) zugekehrten Innenseite des Wandelementes (30,40) ein Dichtelement angebracht ist.

7. Gestellrahmen nach einem der Ansprüche 1 bis 6,
dadurch gekennzeichnet,
daß die Befestigungsstege (11,21,22) mit Hinterschnitt ausgebildet sind und am vorderen Träger (10) und am hinteren Träger (20) gegeneinander gerichtet sind.

8. Gestellrahmen nach einem der Ansprüche 1 bis 7,
dadurch gekennzeichnet,
daß das Befestigungselement (60) zwei zueinander parallel beabstandete Schenkel (63,64) aufweist, die den Befestigungssteg (11,21,22) beidseitig übergreifen,
daß der dem Wandelement (30,40) zugekehrte Schenkel (63) eine Schraubenaufnahme (62) und der dem Wandelement (30,40) abgekehrte Schenkel (64) fluchtend zur Schraubenaufnahme (62) eine Gewindeaufnahme (61) aufweist,
daß das Wandelement (30,40) fluchtend zur Schraubenaufnahme (62) eine weitere Schraubenaufnahme (32) aufweist, und
daß eine Befestigungsschraube (70) in die Schraubenaufnahme (32,62) eingeführt und in die Gewindeaufnahme (61) eingeschraubt ist.

9. Gestellrahmen nach Anspruch 8,
dadurch gekennzeichnet,
daß die Schenkel (63,64) des Befestigungselementes (60) parallel zu dem Wandelement (30,40) stehen und an den vorderen Trägern (10) zur Vorderseite und an den hinteren Trägern (20) zur Rückseite des Gestellrahmens hin gerichtet sind.

10. Gestellrahmen nach einem der Ansprüche 1 bis 9,
dadurch gekennzeichnet,
daß die Längsaufnahmen (15) an den einander zugekehrten Innenseiten der vorderen Träger (10) als Absätze ausgebildet sind, die zur Vorderseite hin in einen Anschlag (16) übergehen.

11. Gestellrahmen nach einem der Ansprüche 1 bis 10,
dadurch gekennzeichnet,
daß der vordere Träger (10) einen längsgerichteten Haltesteg (18) aufweist, an dem ein U-förmiges Befestigungselement (60) längs verschiebbar ist, und
daß in einen parallel zur Außenfläche des vorderen Trägers (10) verlaufenden Schenkel (53) der Halterung (50) ein in Richtung der Tiefe des Gestellrahmens verlaufendes Langloch (52) eingebracht ist, in das eine Befestigungsschraube (55) einführbar und mit einer Gewindeaufnahme des Befestigungselementes (60) verschraubbar ist.

12. Gestellrahmen nach Anspruch 11,
dadurch gekennzeichnet,
daß der Haltesteg (18) gegenüber der Außenseite des vorderen Trägers (10) parallel nach innen versetzt ist und sich an die Längsaufnahme (15) des vorderen Trägers (10) anschließt.

13. Gestellrahmen nach Anspruch 11 oder 12,
dadurch gekennzeichnet,
daß das Befestigungselement (60) zwei den Haltesteg (18) beidseitig übergreifende Schenkel (63,64) aufweist, von denen der der Halterung (50) abgekehrte Schenkel (64) die Gewindeaufnahme (61) und der der Halterung (50) zugekehrte Schenkel (63) eine hierzu fluchtende Schraubenaufnahme (62) aufweist.

14. Gestellrahmen nach einem der Ansprüche 11 bis 13,
dadurch gekennzeichnet,
daß die Schenkel (63,64) des Befestigungselementes (60) zur Vorderseite des Gestellrahmens hin gerichtet sind.

15. Gestellrahmen nach einem der Ansprüche 11 bis 14,
dadurch gekennzeichnet,
daß die Halterung (50) mit seinem Schenkel (53) auf einer Tiefenstrebe (90) aufgeschraubt ist, und
daß die Tiefenstrebe (90) mit einem Halteansatz (91) an dem vorderen Träger (10) befestigt ist.

16. Gestellrahmen nach Anspruch 15,
dadurch gekennzeichnet,
daß der Halteansatz (91) der Tiefenstrebe (90) mittels des Befestigungselementes (60) an dem Haltesteg (18) des vorderen Trägers (10) festlegbar ist.

## Claims

1. Framework, including two front and two rear vertical supports, which framework is closable by means of wall elements apart from the front side, and structural units are installable in said framework via the open front side, holders being mounted or mountable on the two front supports, and the structural units being securable on said holders, characterised in that elongate slots (23,24) are provided in the external sides of the rear supports (20), which sides extend perpendicular to one another, for receiving angled edges (31,41) of the wall elements (30,40), in that the rear supports (20) have securing webs (21,22), which extend parallel to the wall elements (30,40) with a spacing therebetween, for securing adjustable U-shaped securing elements (60), on which the wall elements (30,40) are mountable, in that the front supports (10) have elongate slots (13) on their lateral external faces (14) to receive angled edges (31) of the lateral wall elements (30), in that the front supports (10) have securing webs (11), which extend parallel to these wall elements (30) with a spacing therebetween, for securing adjustable U-shaped securing elements (60), on which these wall elements (30) are mountable, and in that the front supports (10) have elongate receiving means (15) for the holders (50) on the internal faces extending parallel to the lateral external faces (14), the holders (50) being mountable on said holders so as to be adjustable in respect of depth.

2. Framework according to claim 1, characterised in that a vertical bearing web (12), which is offset relative to the external side of the support (10,20) in a direction towards the interior of the framework, is disposed on the support (10,20), in that the securing web (11,21,22) is offset relative to the bearing web (12) in a direction towards the interior of the framework, and in that the wall element (30,40) is supported with its internal side on the bearing web (12).

3. Framework according to claim 2, characterised in that the bearing web (12) of the support (10,20) is offset relative to the external side of the support (10,20) by an amount corresponding to the thickness of the wall element (30,40).

4. Framework according to claim 2 or 3, characterised in that the bearing web (12) communicates with the elongate slot (13,23,24) of the support (10,20).

5. Framework according to one of claims 1 to 4, characterised in that sealing elements are inserted or insertable in the elongate slot (13,23,24) of the support (10,20).

6. Framework according to one of claims 2 to 4, characterised in that a sealing element is mounted on the bearing web (12) or on the internal side of the wall element (30,40) facing the bearing web (12).

7. Framework according to one of claims 1 to 6, characterised in that the securing webs (11,21,22) are provided with an undercut and orientated towards one another on the front support (10) and on the rear support (20).

8. Framework according to one of claims 1 to 7, characterised in that the securing element (60) has two legs (63,64), which extend parallel to each other with a spacing therebetween and bilaterally engage over the securing web (11,21,22), in that the leg (63) facing the wall element (30,40) has a screw receiving means (62), and the leg (64) remote from the wall element (30,40) has a threaded receiving means (61) in alignment with the screw receiving means (62), in that the wall element (30,40) has an additional screw receiving means (32) in alignment with the screw receiving means (62), and in that a securing screw (70) is introduced into the screw receiving means (32,62) and screwed into the threaded receiving means (61).

9. Framework according to claim 8, characterised in that the legs (63,64) of the securing element (60) extend parallel to the wall element (30,40) and are orientated towards the front side of the framework on the front supports (10) and towards the rear side of the framework on the rear supports (20).

10. Framework according to one of claims 1 to 9, characterised in that the elongate receiving means (15) are configured as shoulder portions on the internal sides of the front supports (10) facing one another, and said shoulder portions extend towards the front side into a stop member (16).

11. Framework according to one of claims 1 to 10, characterised in that the front support (10) has a longitudinally orientated retaining web (18), on which a U-shaped securing element (60) is longitudinally displaceable, and in that an elongate hole (52), which extends towards the depth of the framework, is provided in a leg (53) of the holder (50) extending parallel to the external face of the front support (10), a securing screw (55) being insertable into said hole and being screw-connectable with a threaded receiving means of the securing element (60).

12. Framework according to claim 11, characterised in that the retaining web (18) is offset in an inwardly parallel manner relative to the external side of the front support (10) and communicates with the elongate receiving means (15) of the front support (10).

13. Framework according to claim 11 or 12, characterised in that the securing element (60) has two legs (63,64), which bilaterally engages over the retaining web (18), the leg (64) remote from the holder (50) having the threaded receiving means (61), and the leg (63) facing the holder (50) having a screw receiving means (62) in alignment therewith.

14. Framework according to one of claims 11 to 13, characterised in that the legs (63,64) of the securing element (60) are orientated towards the front side of the framework.

15. Framework according to one of claims 11 to 14, characterised in that the holder (50) is screwed onto a depth bar (90) by means of its leg (53), and in that the depth bar (90) is secured on the front support (10) by means of a securing extension (91).

16. Framework according to claim 15, characterised in that the securing extension (91) of the depth bar (90) is securable on the retaining web (18) of the front support (10) by means of the securing element (60).

## Revendications

1. Ossature d'armoire avec deux montants verticaux avant et deux montants verticaux arrière, ossature qui sauf en ce qui concerne le côté antérieur peut être cloisonnée avec des éléments de cloison et dans laquelle des modules peuvent être montés au travers le côté avant, des supports étant ou pouvant être fixées sur les deux montants avant, supports auxquels peuvent être fixés les modules,
caractérisée
en ce que dans les côtés extérieurs perpendiculaires l'un à l'autre des montants arrière (20) sont pratiquées des fentes longitudinales (23, 24) aux fins de la réception de bords coudés (31, 41) des éléments de cloison (30, 40),
en ce que parallèlement aux éléments de cloison (30, 40) les montants arrière (20) présentent des nervures de fixation (21, 22) distantes les unes des autres pour des éléments de fixation en forme de U mobiles, auxquels peuvent être fixés les éléments de cloison (30, 40),
en ce que dans les faces extérieures latérales (14), les montants avant présentent des fentes longitudinales (13) pour la réception de bords coudés (31) des éléments de cloison latéraux (30),
en ce que parallèlement à ces éléments de cloison (30), les montants avant présentent des nervures de fixation (11), distantes les unes des autres, pour les éléments de fixation en forme de U (60) mobiles, auxquels peuvent être fixés lesdits éléments de cloison (30), et
en ce que sur les faces intérieures parallèles aux faces latérales extérieures (14), les montants présentent des logements longitudinaux (15) pour les éléments de fixation, logements dans lesquels les supports (50) peuvent être montés de manière réglable en profondeur.

2. Ossature suivant la revendication 1,
caractérisée
en ce qu'une nervure de butée (12) verticale décalée en direction de l'enceinte intérieure de l'ossature par rapport à la face extérieure du montant (10, 20) est prévue sur le montant (10, 20),
en ce que la nervure de fixation (11, 21, 22) est décalée en direction de l'enceinte intérieure de l'ossature par rapport à la nervure de butée (12), et
en ce que par sa face intérieure, l'élément de cloison (30, 40) s'appuie sur la nervure de butée (12).

3. Ossature suivant la revendication 2,
caractérisée
en ce que par rapport à la face extérieure du montant (10, 20), la nervure de butée (12) du montant (10, 20) est décalée vers l'arrière de l'épaisseur de l'élément de cloison (30, 40).

4. Ossature suivant la revendication 2 ou 3,
caractérisée
en ce que la nervure de butée (12) se raccorde à la fente longitudinale (13, 23, 24) du montant (10, 20).

5. Ossature suivant l'une quelconque des revendications de 1 à 4,
caractérisée
en ce que des éléments d'étanchéités sont posés ou peuvent être posés dans la fente longitudinale (13, 23, 24) du montant (10, 20).

6. Ossature suivant l'une quelconque des revendications de 2 à 4,
caractérisée
en ce qu'un élément d'étanchéité est fixé sur la nervure de butée (12) ou sur la face intérieure de l'élément de cloison (30, 40) qui est orientée vers la nervure de butée (12).

7. Ossature suivant l'une quelconque des revendications de 1 à 6,
caractérisée
en ce que les nervures de fixation (11, 21, 22) sont formés en dépouille et sont dirigés l'une vers l'autre sur le montant avant (10) et sur le montant arrière (20).

8. Ossature suivant l'une quelconque des revendications de 1 à 7,
caractérisée
en ce que l'élément de fixation (60) présente deux ailes (63, 64) parallèles distantes l'une de l'autre, qui enserrent de part et d'autre la nervure de fixation (11, 21, 23),
en ce que l'aile (63) orientée vers l'élément de cloison (30, 40) présente une ouverture pour vis (62) et en ce que l'aile (64) non orientée vers l'élément de cloison (30, 40) présente une ouverture filetée (61) en alignement avec l'ouverture pour vis (62),
en ce que l'élément de cloison (30, 40) présente une ouverture pour vis supplémentaire (32) en alignement avec l'ouverture pour vis (62), et
en ce qu'une vis de fixation (70) est introduite dans l'ouverture pour vis (32, 62) et est vissée dans l'ouverture filetée (61).

9. Ossature suivant la revendication 8,
caractérisée
en ce que les ailes (63, 64) de l'élément de fixation (60) sont parallèles à l'élément de cloison (30, 40) et, sur les montants avant (10) sont orientées vers le côté avant de l'ossature, tandis que sur les montants arrière (20), elles sont orientées vers le côté arrière de l'ossature.

10. Ossature suivant l'une quelconque des revendications de 1 à 9,
caractérisée
en ce que les logements longitudinaux (15) sur les côtés intérieurs de faisant face des montants avant (10) ont la forme d'épaulements, qui en direction du côté avant se raccordent à une butée (16).

11. Ossature suivant l'une quelconque des revendications de 1 à 10,
caractérisé
en ce que le montant avant (10) présente une nervure de fixation (18) orientée longitudinalement, sur laquelle peut être déplacée à glissement un élément de fixation (60) en forme de U, et
en ce que dans une aile (53) du support (50), disposée parallèlement à la face extérieure du montant avant (10), est pratiquée un trou oblong (52) disposée dans la direction de la profondeur de l'ossature, trou dans lequel peut être introduite une vis de fixation (55) qui peut être vissée dans une réception filetée de l'élément de fixation (60).

12. Ossature suivant la revendication 11,
caractérisée
en ce que la nervure de fixation (18) est, par rapport à la face extérieure du montant avant (10), décalée parallèlement vers l'intérieur et se raccorde au logement longitudinal (15) du montant avant (10).

13. Ossature suivant la revendication 11 ou 12,
caractérisée
en ce que l'élément de fixation (60) présente deux ailes (63, 64) enserrant de part et d'autre la nervure de fixation (18), ailes dont celle (64) qui n'est pas orientée vers le support (50) présente l'ouverture filetée (61) et dont celle (63) qui est orientée vers l'élément de support (50) présente l'ouverture pour vis (62).

14. Ossature suivant l'une quelconque des revendications de 11 à 13,
caractérisée
en ce que les ailes (63, 64) de l'élément de fixation (60) sont dirigées vers le côté avant de l'ossature.

15. Ossature suivant l'une quelconque des revendications de 11 à 14,
caractérisée
en ce que le support (50) est, par son aile (53), vissée sur une entretoise de profondeur (90), et
en ce que l'entretoise de profondeur (90) est par un épaulement de fixation (91) fixée au montant avant (10).

16. Ossature suivant la revendication 15,
caractérisée
en ce que l'épaulement de fixation (91) de l'entretoise de profondeur (90) peut par l'intermédiaire de l'élément de fixation (60) être bloquée sur la nervure de fixation (18) du montant avant (10).
